# EUROPEAN PATENT APPLICATION

(11) **EP 4 844 367 A1**
(43) Date of publication of application: **25.11.2026**
(21) Application number: 25178514.3
(22) Date of filing: 23.05.2025
(51) Int. Cl.: G01N 1/32, H01J 37/302, H01J 37/305

(54) **ION MILLING APPARATUS, CONTROLLING METHOD AND APPARATUS**

(71) Applicant: Leica Mikrosysteme GmbH, 1170 Wien (AT)
(72) Inventor: PLANK, Heinz, 1170 Wien (AT); WINKLER, Konrad, 1170 Wien (AT); LOCHER, Rainer, 1170 Wien (AT); WOGRITSCH, Rainer, 1230 Wien (AT)
(74) Representative: 2SPL Patentanwälte PartG mbB

(57) **Abstract**

Examples relate to an ion milling method. The method comprises obtaining process data indicative of a first incidence angle at which a sample is to be milled and a position of an ion source relative to the sample. The method further comprises controlling movement of the ion source for milling the sample based on the process data.

## Description

### Technical field

Examples relate to material-removal techniques, specifically to ion-milling. Examples relate to a controlling method and apparatus to control an ion milling apparatus as well as to an ion milling apparatus.

### Background

Flat milling is widely used to produce damage-free, planar cross-sections of metals, semiconductors, ceramics, and composite materials. An ion mill directs a broad, low-divergence ion beam onto the sample surface, e.g., at a shallow, non-normal incidence angle α. Material is sputtered away until a desired surface finish or cross-section depth is reached.

In practice the process is executed as a sequence of discrete milling steps: In an irradiation phase, the sample is exposed to the ion beam at a defined first incidence angle α₁ with predefined ion-source parameters (ion energy, beam current, beam current density, etc.) for a dwell time that usually ranges from a few seconds to several minutes. In a parameter-adjust phase, milling is paused, α is modified, yielding α₂, to improve removal geometry or decrease curtaining, and the ion-source parameters are re-set to new values that suit the next step. These steps are repeated until all planned angles have been executed and the surface is fully planarized.

The transition between consecutive milling steps is conventionally performed manually. A skilled operator must therefore tilt the sample stage or the ion source to the next incidence angle, enter new ion-energy and beam-current set points before resuming milling. This manual workflow is time-consuming, as frequent interruptions extend the overall milling time. Further, the whole process depends on skill, attentiveness, and availability of an operator.

Accordingly, there is a need for an improved ion milling.

### Summary

This need is addressed by the subject-matter of the independent claims.

The examples in the present disclosure are based on the insight, that the milling can be executed as a workflow, where the angles and parameters are defined as a sequence of target values and then applied automatically by coordinated motion and beam-setting control, enabling the entire flat-milling process to run unattended with higher precision and throughput.

Examples provide an ion milling method (or controlling method). The method comprises obtaining process data indicative of a first incidence angle and optionally a second incidence angle at which a sample is to be milled. The process data is further indicating a position (e.g., x-y-coordinates) of an ion source relative to the sample. The method further comprises controlling movement of the ion source for milling the sample based on the process data. Because the incidence angle and the position are applied automatically, the milling sequence can proceed without manual intervention, yielding higher throughput. By repositioning the ion source, the sample may either remain stationary or only exhibit back and forth movability (without tilting) which avoids mechanical stress and vibration on the specimen. Further, the stationary stage can be more compact, needs fewer feed-throughs, and keeps electrical connections and cooling lines undisturbed.

When the process data includes an explicit ion-source and/or sample (holder) position, a recipe step may carry not only an incidence angle but also an X-Y-Z (and/or tilt) offset for the ion source relative to the sample. This enables spot-precise milling, drift compensation and recipe flexibility, since combining angle and position in the same recipe lets one sequence both tilt for multi-angle smoothing and translate for raster-style polishing.

In an example, the movement of the ion source is controlled for milling the sample at the first incidence angle and subsequently controlled for milling the sample at the second incidence angle. By sequentially adjusting the ion source, the same surface area is irradiated from two distinct directions without realignment.

In an example, the process data is preferably fully obtained before the milling of the sample at the first incidence angle ends or the process data is preferably fully obtained before the milling of the sample at the first incidence angle starts. Because all required process data are already available before the first milling step finishes (or even begins), the controller can transition to the next incidence angle without pausing for additional measurements or user input, eliminating idle time between passes and further increasing overall throughput and reproducibility.

In an example, the process data is further indicative of a first parameter and a second parameter of the ion source. The method further comprises setting the ion source based on the first parameter for milling the sample with the first incidence angle and setting the ion source based on the second parameter for milling the sample with the second incidence angle. Pre-loading and automatically applying angle-specific ion-source parameters ensures that each milling pass is executed under its individually optimized conditions. This yields a uniform sputter rate and surface finish and eliminates manual retuning. For example, the first or second parameter indicates an energy or intensity of an ion beam to be generated by the ion source.

In an example, the method further comprises obtaining sample data indicative of a parameter of the sample. The target incidence angle or parameter of the ion source are determined or adjusted based on the sample data. Deriving the milling recipe directly from measured sample data lets the method tailor incidence angles and beam settings to characteristics of the sample, e.g., material and geometry of the specimen or milling result of a previous milling step.

In an example, the movement of the ion source is controlled by controlling a movable mount holding the ion source. Using a dedicated movable mount to position the ion source allows precise multi-axis adjustments with minimal inertia.

In an example, the process data is obtained by receiving user input data indicating an input of a user. Accepting process data via direct user input gives operators the flexibility to tailor incidence angles and beam parameters themselves while still leaving the actual milling sequence fully automated.

Examples provide a controlling apparatus. The controlling apparatus comprises processing circuitry configured to execute the ion milling method as described above.

Examples provide an ion milling apparatus. The ion milling apparatus comprises a vacuum housing and an ion source. The ion source is movable relative to the vacuum housing. Making the ion source movable relative to the fixed vacuum housing allows the beam orientation to be changed without breaking vacuum or disturbing the specimen. This enables multi-angle milling while preserving sample alignment.

In an example, the ion source is movable laterally relative to a sample to be milled. Lateral mobility lets the ion source sweep across the specimen surface, achieving uniform material removal over larger areas without moving the sample itself. Lateral mobility may be provided by a movable mount holding the ion source. That is, the lateral position of the ion source relative to the sample can be adjusted by moving the ion source. Optionally, either the ion source and/ or the sample holder can be moved angularly and/or translationally relative to the other to provide additional control over the beam's incidence angle and working distance. Examples provide an ion milling apparatus. The ion milling apparatus comprises a plurality of ion sources. Each of the plurality of ion sources is configured to be operated in a different mode. For example, the ion milling apparatus may comprise at least three ion sources and at least two of the three ion sources may be operated in a different mode. Having multiple ion sources that simultaneously mill separate regions of the same specimen enables parallel processing for shortening total milling time.

In an example, a first ion source of the plurality of ion sources is configured to mill a sample, yielding an ablation region, and a second ion source of the plurality of ion sources is configured to polish the ablation region. Because the apparatus carries several independently addressable ion sources, each can be dedicated to a different task - e-g., one for high-rate bulk removal and another for low-energy polishing. Thus, the apparatus can implement coarse milling and fine surface finishing without tool-changes, re-alignment, or venting.

In an example, the plurality of ion sources comprises at least two ion sources which are independently movable. For example, at least one of the plurality of ion sources is tiltable relative to the sample or sample holder. By equipping at least two ion sources with independent mobility (e.g., one or more tiltable), the apparatus can dynamically tailor each beam's incidence angle and position without mutual interference. This enables simultaneous multi-angle processing and region-specific customization.

Various examples of the present disclosure relate to a corresponding computer program with a program code for performing the above method when the computer program is executed on a processor.

### Short description of the Figures

Some examples of apparatuses and/or methods will be described in the following by way of example only, and with reference to the accompanying figures, in which
Fig. 1 shows a flowchart of an example of an ion milling method;
Fig. 2 shows a schematic diagram of an example of an ion milling apparatus for flat milling;
Fig. 3 shows a block diagram of an example of a controlling apparatus for executing an ion milling method as described herein;
Fig. 4 shows a block diagram of an example of an ion milling apparatus with a movable ion source; and
Fig. 5 shows an example of an arrangement of three ion sources;
Fig. 6a shows a schematic diagram of an example of an ion milling system during ion milling of a sample; and
Fig. 6b shows a schematic diagram of an example of an ion milling system during observation of a sample.

### Detailed Description

Various examples will now be described more fully with reference to the accompanying drawings in which some examples are illustrated. In the figures, the thicknesses of lines, layers and/or regions may be exaggerated for clarity.

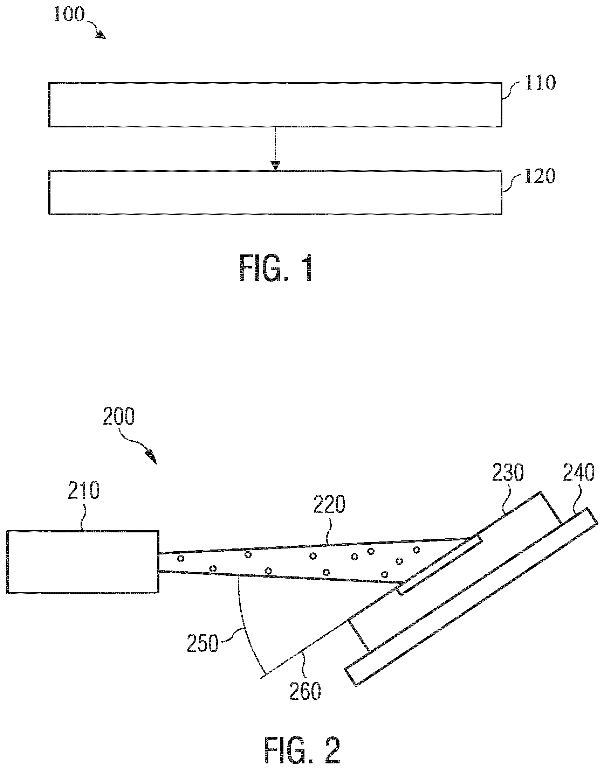

Fig. 1 shows a flowchart of an example of an ion milling method 100. The ion milling method 100 may be a computer-implemented method for controlling an ion milling machine or apparatus. For instance, the method 100 may be executed by an apparatus comprising at least one of processors, software, volatile memory, e.g., for storing real-time variables, and non-volatile storage, e.g., for storing the milling recipe and software, and I/O interfaces. For instance, one or more CPUs (Central Processing Units) or microcontrollers, embedded processors may execute a program code stored in memory. Digital/analog I/O may send commands to - and read feedback from - the milling hardware.

Ion milling (also called ion beam milling or ion beam sputtering) is a physical etching process in which a focused or broad beam of energetic ions, e.g., argon ions, is directed at a solid surface under vacuum. The impinging ions transfer momentum to surface atoms, sputtering them away to remove material in a controlled manner. An ion milling apparatus is the integrated hardware system that generates, directs, and controls the ion beam under vacuum conditions. It may comprise a sealed enclosure maintained at high vacuum, entry ports for inserting and retrieving samples, a sample stage and an ion source (ion gun).

The method 100 comprises obtaining 110 process data indicative of a first incidence angle and optionally a second (different) incidence angle at which a sample is to be milled. The incidence angle (e.g., α) may be the angle between the central axis of the incoming ion beam and the surface normal of the sample. At α = 0°, the beam strikes the surface perpendicularly; as α increases toward 90°, the beam becomes more grazing. This angle controls the sputter yield, material-removal rate, and surface-planarity during ion milling.

The process data is further indicative of a position of an ion source relative to the sample. The "position" of the ion source in the process data can take any form that indicates the controller where to point the beam relative to the sample. For instance, the position may be indicated as cartesian offsets (e.g., lateral shifts parallel to the sample surface and/or stand-off height above the sample), as angular coordinates (e.g., tilt (pitch) and swing (yaw) or roll), stage-centric position (e.g., absolute stage coordinates or values in the machine's work-coordinate system, relative offset or displacements from the current or home position) or alike. A controller may parse the position, e.g. lateral offsets or height, alongside the angle from the process-data structure. A motion planner converts those coordinates into individual axis setpoints for the ion-source mount or the sample holder (stepper/servo motors). That is, the process data may allow to fully define which region of the sample is to be exposed to the ion beam of the ion source. For example, the region of the sample to be ablated, e.g., an ablation region, can be determined based on the process data.

"Obtaining process data" may comprise receiving the data, retrieving the data from storage, determining, measuring or computing the data. For example, the process data may be obtained by receiving user input data indicating an input of a user. That is, an operator can type (or otherwise enter) the needed angles and optionally other parameters into a control executing the method 100. For instance, a GUI (Graphical User Interface), touch-screen panel or command-line interface presents input fields, like "First incidence angle," "Second incidence angle," and any other beam parameters (energy, current, etc.). Alternatively, the HMI (Human-Machine Interface) may be a separate device communicating over an, e.g., CAN (Controller Area Network) bus. Once validated, an input-handler writes the values into a structured data object. The main milling routine invokes an API call based on that data object. Because the data is available ahead of time, the control loop can immediately proceed to step 110. For instance, the input-handler marshals the user values into packets, sends them to the PLC (Programmable Logic Controller) or motion controller, which then unpacks them for controlling the movement of the ion source accordingly.

With respect to measuring process data, method 100 may include obtaining sample data indicative of at least one parameter of the sample. Obtaining 110 the process data may then comprise determining or adjusting the process data or the first and/or second angle based on the sample data. For instance, the first incidence angle and/or the second incidence angle or other process parameters may be (re-) determined based on a measurement (sample data) of the sample. "Sample data" may be, e.g., thickness or topography from an optical profiler or stylus profilometer; composition or crystallographic orientation from an in-situ detector; hardness or density from an acoustic or ion-beam-based sensor. The sample data may then be used to set angles or other process data: Based on the measured parameter, it may compute a specific first and/or second incidence angle for that specific material and geometry.

For instance, an operator may import or enter specimen-specific technical data, such as lithography mask designs, layer thicknesses, and material compositions, directly into the milling recipe. Upon loading this information (for example, via CAD file upload or manual input), the method 100 may automatically map critical mask features to appropriate beam-parameter sets, tilt angles, and dwell times.

The method 100 may also allow the operator to upload a CAD model file of the sample, e.g., with typography and lithography-mask layouts, into the control software. Upon import, the software may analyze the mask geometry and layer specifications, then integrates this information into the flat-milling workflow. Based on the extracted design data, the method 100 may either recommend an appropriate predefined recipe or automatically generate a fully customized milling recipe optimized for the specific sample, e.g., chip, layout.

Obtaining 110 the process data may alternatively or additionally comprise receiving the data (as user input, remote download, e.g. from a laboratory information system or cloud database, or via inter-tool communication, if another piece of equipment supplies pre-characterized angles), retrieving the data from on-board memory (e.g. fetching previously stored recipes or calibration tables), from local database lookup (e.g. reading a lookup table of optimal angles for given materials) or determining the data by sensor measurement, by calculation or interpolation (e.g., computing target angles based on desired sputter rate or simulating optimal sequences), or by algorithmic generation.

The method 100 further comprises controlling 120 movement of the ion source for milling the sample based on the process data. For instance, a controller loads the desired incidence angle (first and optionally second incidence angles) and the position from the process data and converts them to motion commands. For example, it translates the angle and position into actuator setpoints for a movable ion-source mount (e.g., tilt and/or translation axes).

The method 100 may provide a library of preconfigured flat-milling recipes, each with its own predefined process data. A recipe can be selected by an operator (for example, a "polishing" recipe). Upon selection, all required incidence angles, beam-parameter sets, dwell times, and motion sequences are loaded automatically, ensuring consistent execution without manual configuration. Operators may further customize any recipe or save new, user-defined recipes for future reuse.

The method 100 may automate motion of the sample stage and/or the ion-source mount with respect to the position from the process data, whereas the angle is realized via moving the ion source. The stage is motorized to translate the sample forward/backward (along the beam axis) or laterally (side-to-side in the X-Y plane), while the ion source mount can execute the required tilt. By coordinating stage translation with source orientation for each recipe step, the method 100 achieves precise beam positioning and incidence-angle control.

Controlling 120 the movement may comprise controlling the movement of the ion source for milling the sample at the first incidence angle and subsequently controlling the movement of the ion source for milling the sample at the second incidence angle. First, the controller tilts or translates the ion source to the first specified incidence angle and initiates milling, e.g., under closed-loop feedback. Once that step finishes, it automatically repositions the ion source to the second specified angle. Milling then resumes at the new angle without manual intervention.

The process data may be preferably fully obtained before the milling of the sample at the first incidence angle ends or the process data may be preferably fully obtained before the milling of the sample at the first incidence angle starts. The controller thus gathers all required process data during or before the first-angle milling run so that, by the time that step completes, the parameters for the next incidence angle are already loaded, allowing the multi-angle sequence to be pre-configured. Both approaches remove any idle time for data retrieval. However, measurements during the process may be taken as a basis to modify the angles or other process parameters.

The process data is optionally further indicative of a first parameter and a second parameter of the ion source. The method 100 may then further comprise setting the ion source based on the first parameter for milling the sample with the first incidence angle and setting the ion source based on the second parameter for milling the sample with the second incidence angle. That is, the process data can include two distinct ion-source parameters - one for the first incidence angle and another for the second. For example, the parameter may be a certain value of energy, current or intensity of the ion beam. During execution, the controller applies the first parameter when positioning the ion source at the first angle and mills the sample accordingly. It then automatically switches to the second parameter as it repositions the ion source to the second angle, ensuring each milling pass uses its optimized settings.

The method 100 may support defining and executing multiple operational modes, such as coarse milling, fine finishing, and polishing, rather than only addressing different sample regions. When a user selects a recipe, the controller steps through each mode in sequence, automatically adjusting beam energy, incidence angle, scan pattern, and dwell time as specified. This multi-modal workflow lets complex flat-milling processes run end-to-end under a single, unified recipe. Multiple operational modes of an ion source my be part of recipe.

In a concrete implementation, the ion-milling method 100 is driven by a user-defined, multistep recipe that the method executes automatically. After the operator loads the sample and selects a recipe, the controller sequences through each recipe step by motorizing the ion-source tilt (and any sample-stage axes) to a programmed incidence angle, applies the corresponding ion-source and stage parameter set, and mills for the specified dwell time. It then advances to the next recipe step - adjusting to the next angle and parameter set - until all steps have been completed without further user intervention.

Fig. 2 shows a schematic diagram of an example of an ion milling apparatus 200 for flat milling. The figure is a side-view schematic of a flat-milling setup using an ion source (ion gun) 210. On the left, a block illustration of the ion source 210 is shown: the ion source 210 emits a broad Argon beam 220 (shown as a cone with symbols indicating scattered ions). That beam 220 strikes the sample (specimen) 230 which is held by a holder 240 (light gray). A small bright region on the specimen 230 indicates the surface area exposed to the ions. The beam's central axis makes an oblique incidence angle (α) 250 relative to the sample's surface normal 260. By tilting a holder or mount of the ion gun 210, α can be adjusted to control how "grazing" or "steep" the ions strike the sample 230 for material removal.

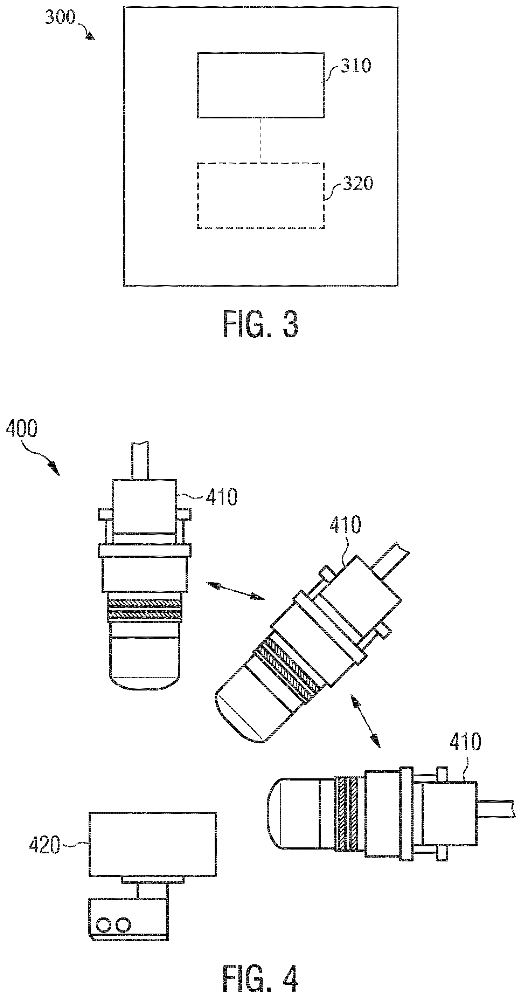

Fig. 3 controlling apparatus 300 for executing an ion milling method as described herein, e.g., method 100. The processing circuitry 310 may comprise hardware, software and/or firmware (or embedded software) for executing computational tasks within the apparatus 300. The processing circuitry 310 may include, e.g., one or more processors (e.g., CPUs (central processing units), microcontrollers, or FPGAs (field-programmable gate arrays) that run algorithms and memory modules (RAM (random-access memory, flash) to store program code or intermediate results.

The controlling apparatus 300 may optionally comprise interface circuitry 320 coupled to the processing circuitry 310. The interface circuitry 320 may, for instance, include any interface (e.g., high-speed data buses, camera links) to receive process data from a HMI and send the received data to the processing circuitry 310. The interface circuitry 320 may send control signals to the actuator of a movable mount holding an ion source.

Fig. 4 shows a block diagram of an example of an ion milling apparatus 400 with a movable ion source 410. The ion milling apparatus 400 comprises a vacuum housing (not shown). The ion source 410 is movable relative to the vacuum housing.

The vacuum housing is a sealed chamber that is pumped down to high vacuum (typically 10⁻⁴-10⁻⁷ mbar) to allow an ion beam to form and travel without scattering. It comprises (or interfaces to) a sample stage, vacuum pumps, pressure sensors, viewports, and feedthroughs for power and control lines (not shown).

The movable ion source 410 may be an ion gun (e.g. Kaufman-type) that is mounted on a motorized manipulator or gimbal inside (or on the flange of) the vacuum housing so that it can change its orientation or position relative to the fixed chamber walls. This movability gives control over the beam's incidence angle without touching the sample 420 or breaking vacuum.

Between the ion source 410 and the vacuum housing there is a mechanical interface (not shown), e.g., a tilt stage or multi-axis manipulator driven by a stepper or servo motor. Encoders on these axes may feed back actual angle or position to the controller to ensure the movement of the ion source 410 is correct.

An optional central controller (not shown) such as the controlling apparatus 300 may hold the flat-milling recipe, including target angles and beam parameters. It may send commands to the actuators to reposition the ion source 410 and to the ion-source power supplies to set voltage/current, for instance.

The ion source 410 is shown in three positions, for illustrative purposes, with respective distinct orientations. In the top-mounted position (0° / normal incidence), the ion source 410 is pointed straight down onto the sample 420 for perpendicular milling or bulk material removal.

In the mid-tilt position (~45° incidence), the ion source 410 is angled part-way over and provides an intermediate incidence angle, e.g., for balancing sputter rate or surface smoothness. In the grazing-angle position (~80° incidence), the ion source 410 is nearly horizontal, this beam skims the surface for low-damage polishing or to decreasing curtaining.

Because the ion source 410 itself is movable relative to the static vacuum housing, the apparatus 400 can automatically sweep through multiple programmed angles - optionally each with its own beam-parameter set - without ever venting the chamber or without moving the sample stage. This yields unattended, repeatable flat-milling recipes with less idle time between steps.

The ion source 410 may further be movable laterally and optionally angularly and/or translationally relative to a sample to be milled. A lateral movement means movement of the ion source 410 in a direction parallel to the plane of the sample surface - that is, shifting it side-to-side or back-and-forth. Allowing the ion source 410 to translate laterally (i.e., in the X-Y plane) over a stationary sample lets the beam sweep across the surface without a need to move the specimen 420. A motor-driven translation stage carries the ion source 410. This lateral mobility ensures uniform material removal over large areas, reduces edge effects, and eliminates stage-motion-induced vibration or misalignment during milling.

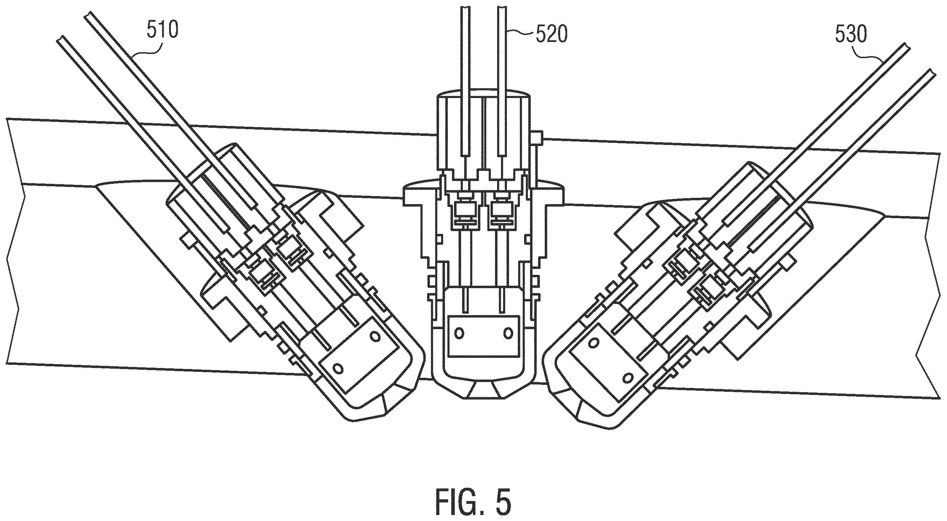

Fig. 5 shows an example of an arrangement of three ion sources 510, 520, 530. The ion source 510, 520, 530 may be part of an ion milling apparatus. Each of them is configured to be operated in a different mode. At least two of the three ion sources are configured to operate in a different mode, e.g., with parameter sets optimized for, e.g., scrubbing, coarse milling, fine finishing, or polishing. Accordingly, the beam energy (or energy density), current, position, and/or incidence angle of the at least two ion sources may vary depending on the selected mode. In other examples, the ion milling apparatus may have a higher or lower number of ion sources or may have a different arrangement of its ion sources.

Fig. 5 is a cutaway view of the three ion sources 510, 520, 530 mounted in a common flange above a sample plane, each oriented at a different angle. At the rear of each source there are gas-feed tubes supplying argon into the plasma chamber, where a cathode assembly ionizes the gas. Forward of the plasma region sits a multi-grid system wit stacked electrodes that extracts and accelerates the ions into a coherent beam, then focuses it toward the sample.

Fig. 5 shows a triangular arrangement of the ion sources 510, 520, 530. The center source 520 points straight down (normal incidence) for bulk removal, while the left and right sources 510, 530 are inclined at complementary oblique angles for medium- and grazing-angle milling or polishing.

In other examples than the one shown in Fig. 5, the plurality of ion sources of the ion milling apparatus may comprise at least two ion sources which are independently movable. For instance, at least one of the plurality of ion sources may be tiltable relative to the sample or a sample holder. Unlike the fixed-angle trio shown in Figure 5, two or more ion guns can be equipped each with their own dedicated motion axes. Then, each source can pivot about its own hinge or gimbal. By making each ion source independently movable (e.g., tiltable), the apparatus gains flexibility for multi-angle, multi-task workflows with high levels of automation.

Alternatively, ion sources may be deployed, e.g., sequentially or in parallel, for both aggressive "scrubbing" (bulk material removal) and gentle polishing operations. In a scrubbing mode, each source is driven at higher beam current and at angles chosen to increase sputter rate, while in a polishing mode the same sources operate at lower energy and grazing angles to achieve a smooth finish.

Optionally, the recipe described above may also specify the sequential execution of different operating modes for the ion source. For example, an ion source may be operated sequentially in two different modes during the execution of a recipe.

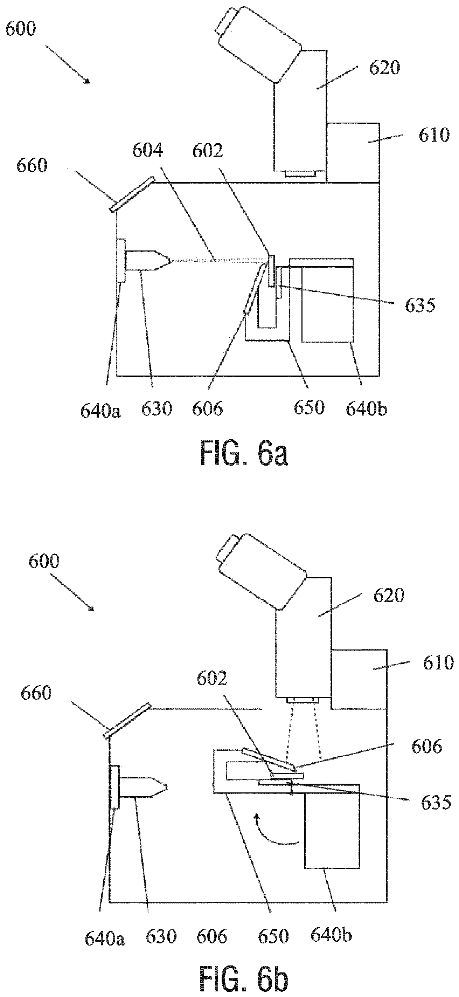

Fig. 6a shows a schematic diagram of an example of an ion milling system 600 during ion milling of a sample 602. An ion milling system 600 typically comprises several components. These include at least one ion emitter 630, which comprises the ion source that generates the ion beam 604 (commonly using Argon gas) and ion optics, which are used to direct the ion beam 604 onto the sample 602. A mechanical ion beam positioning system 640a is used to target the sample 602 by adjusting at least one of a lateral position, vertical position, or orientation of the at least one ion emitter 630.

A sample stage 650 holds and precisely positions the sample during processing. The sample 602 is attached to a sample holder 635, which is mounted to the sample stage 650. A mask 606 partially shields the sample 602 during ion milling. A mechanical sample stage positioning system 640b is used to position the sample stage 650 with the sample 602 relative to the ion beam 604, with the mechanical sample stage positioning system 640b being configured to adjust at least one of a lateral position, vertical position, or orientation of the sample stage 650, and therefore of the sample 602. The ion milling system 600 may also use vacuum equipment to maintain vacuum conditions, as discussed herein. Finally, a control system 610 controls the operation and parameters of the ion milling process, allowing for adjustments to be made for different applications and material types. The control system 610 can be controlled via a touch-screen display 660, which is coupled to the control system 610.

**In** the ion milling system 600 shown in Figs. 6a and 6b, a digital or hybrid microscope 620 allows a user to inspect the sample 602 that is placed on the sample stage 650. The control system 610 uses image data from the microscope 620, which performs the function of an imaging device. Alternatively, a camera may be placed in the chamber of the ion milling system 600 and be used to monitor the sample before and after the ion milling. As the sputtering leads to deposition of material removed from the sample on the components inside the ion milling chamber, the camera may be shielded from the sample chamber during ion milling, e.g., using a retractable shield, which may be removed periodically or occasionally to allow for monitoring of the progress of the ion milling process.

As shown in Fig. 6b, the sample stage 650 may be moved (e.g., tilted) towards the imaging device, e.g., the microscope 620, for observation. Fig. 6b shows a schematic diagram of an example of an ion milling system 600 during observation of a sample 602, when using the microscope 620 as the imaging device. To allow for observation of the sample 602, the sample stage 650 is tilted upwards by 90 degrees, such that the ion emitter-facing side of the sample now faces towards the microscope 620. As the sample is partially shielded by the mask06, the image data further shows the mask 606 for shielding a further portion of the sample 602.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended.

Furthermore, features of a claim should also be included for any other independent claim, even if that claim is not directly defined as dependent on that other independent claim.

The aspects and features described in relation to a particular one of the previous examples may also be combined with one or more of the further examples to replace an identical or similar feature of that further example or to additionally introduce the features into the further example.

### List of reference Signs

100 method
110 obtaining
120 controlling
200 apparatus
210 ion source
220 ion beam
230 sample
240 holder
250 angle
260 surface normal
300 controlling apparatus
310 processing circuitry
320 interface circuitry
400 ion milling apparatus
410 ion source
420 sample
510, 520, 530 ion sources
600 ion milling system
602 sample
604 ion beam
606 mask
610 control system
620 digital or hybrid microscope (imaging device)
630 ion emitter / ion source
635 sample holder
640a mechanical ion-beam positioning system
640b mechanical sample-stage positioning system
650 sample stage
660 touch-screen display

## Claims

1. An ion milling method (100), comprising:
obtaining (110) process data indicative of a first incidence angle at which a sample is to be milled and a position of an ion source relative to the sample; and
controlling (120) movement of the ion source for milling the sample based on the process data.

2. The ion milling method (100) of claim 1, wherein the process data is further indicative of a second incidence angle at which the sample is to be milled.

3. The ion milling method (100) of claim 2, wherein the movement of the ion source is controlled for milling the sample at the first incidence angle and subsequently controlled for milling the sample at the second incidence angle.

4. The ion milling method (100) of claim 3, wherein the process data is preferably fully obtained before the milling of the sample at the first incidence angle ends or the process data is preferably fully obtained before the milling of the sample at the first incidence angle starts.

5. The ion milling method (100) of any one of the previous claims, wherein the process data is further indicative of a first parameter and a second parameter of the ion source, wherein the method further comprises setting the ion source based on the first parameter for milling the sample with the first incidence angle and setting the ion source based on the second parameter for milling the sample with the second incidence angle.

6. The ion milling method (100) of claim 5, wherein the first or second parameter indicates an energy or intensity of an ion beam to be generated by the ion source.

7. The ion milling method (100) of any one of the previous claims, further comprising obtaining sample data indicative of a parameter of the sample, and wherein
the process data is determined or adjusted based on the sample data.

8. The ion milling method (100) of any one of the previous claims, wherein the movement of the ion source is controlled by controlling a movable mount holding the ion source.

9. The ion milling method (100) of any one of the previous claims, wherein the process data is obtained by receiving user input data indicating an input of a user.

10. An ion milling apparatus (400), comprising:
a vacuum housing; and
an ion source (410), wherein the ion source (410) is movable relative to the vacuum housing.

11. The ion milling apparatus (400) of claim 10, wherein the ion source (410) is movable laterally, angularly or translationally relative to a sample (420) to be milled.

12. An ion milling apparatus (500), comprising:
a plurality of ion sources (510, 520, 530), wherein each of the plurality of ion sources (510, 520, 530) is configured to be operated in a different mode.

13. The ion milling apparatus (500) of claim 12, wherein the plurality of ion sources (510, 520, 530) comprises at least two ion sources which are independently movable.

14. The ion milling apparatus (500) of any one of claims 12 to 13, wherein at least one of the plurality of ion sources (510, 520, 530) is tiltable relative to the sample.

15. The ion milling apparatus (500) of any one of claims 12 to 14, wherein a first ion source (520) of the plurality of ion sources is configured to mill a sample, yielding an ablation region, and wherein a second ion source (510, 530) of the plurality of ion sources is configured to polish the ablation region.
